# DEMANDE DE BREVET EUROPEEN

(11) **EP 1 156 499 A1**
(43) Date de publication de la demande: **21.11.2001**
(21) Numéro de dépôt: 01420110.7
(22) Date de dépôt: 15.05.2001
(51) Int. Cl.: H01G 5/16, B81B 3/00

(54) **Microcomposant électronique du type capacité variable ou microswitch**

(30) Priorité: 15.05.2000 FR 0006142
(71) Demandeur: Memscap, 38330 Saint Ismier (FR); Planhead-Silmag Phs, 75008 Paris (FR)
(72) Inventeur: Charrier, Catherine, 38400 Saint Martin D'Heres (FR); Bouchon, Eric, 38120 Saint Egreve (FR); Campo, Alain, 38590 Sillans (FR); Imbert, Guy, 38100 Grenoble (FR); Valentin, François, 38113 Yeurey Voroize (FR); Basteres, Laurent, 38000 Grenoble (FR)
(74) Mandataire: Palix, Stéphane

(57) **Abrégé**

Procédé de fabrication de microcomposants électroniques, du type capacité variable ou microswitch, comprenant une armature fixe (1) et une membrane (20) déformable situées en regard l'une de l'autre, caractérisé en ce qu'il comporte les étapes suivantes, consistant :
◆ à déposer une première couche métallique sur une couche d'oxyde (2), ladite première couche métallique étant destinée à former l'armature fixe ;
◆ à déposer un ruban métallique (10, 11) sur au moins une partie de la périphérie et de part et d'autre de l'armature fixe (1), ledit ruban étant destiné à servir d'espaceur entre l'armature fixe (1) et la membrane déformable (20) ;
◆ à déposer une couche de résine sacrificielle (15) sur au moins la superficie de ladite armature fixe (1) ;
◆ à générer par lithographie une pluralité de caissons, sur la surface de ladite couche de résine sacrificielle ;
◆ à déposer par électrolyse, à l'intérieur des caissons formés sur la résine sacrificielle (15), au moins une zone métallique destinée à former la membrane déformable (20), cette zone métallique s'étendant entre des sections du ruban métallique (10, 11) situées de part et d'autre de ladite armature fixe (1) ;
◆ à éliminer la couche de résine sacrificielle (15).

## Description

### Domaine technique

L'invention se rattache au domaine de la microélectronique, et plus à celui des composants microsystèmes. Elle concerne plus particulièrement des microcomposants du type microcapacité variable ou microswitch intégrant une membrane déformable sous l'action de forces électrostatiques. Elle vise un procédé particulier permettant d'obtenir de tels microcomposants, qui se révèle nettement avantageux par rapport aux procédés existant.

### Techniques antérieures

De façon connue, les microcomposants du type microcapacité ou microswitch possèdent une plaque ou armature fixe et une membrane mobile, séparées par un volume dont les dimensions sont variables notamment par exemple lorsqu'il existe une différence de potentiel continue entre la plaque fixe et la membrane déformable.

En soumettant la plaque fixe et la membrane mobile à une différence de potentiel particulière, on peut ainsi moduler la valeur nominale de la capacité en fonction de l'application souhaitée.

Dans certains cas de figure, il est également possible de faire en sorte que la membrane mobile se rapproche suffisamment de la plaque fixe pour obtenir un contact. Le composant est alors utilisé en tant que micro-interrupteur ou microswitch.

Les microcomposants de ce type sont généralement obtenus en utilisant des techniques liées au micro-usinage de surface. Classiquement, une telle membrane est obtenue par des procédés réalisés à température élevée, supérieure à 400°C, et plus généralement supérieure aux températures supportables par un semiconducteur fini sans risque de modifier trop fortement ses fonctionnalités.

Un composant est typiquement constitué par un empilement de couches minces, selon la structure classique suivante. Une première couche constitue l'armature ou la plaque fixe de la capacité. Cette couche peut être réalisée en polysilicium de premier niveau lorsque les technologies utilisées sont compatibles avec les procédés de traitement des semi-conducteurs. Cette couche de polysilicium est déposée sur une couche d'oxyde ou de nitrure Dans le document de Darrin J. YOUNG, Bernhard E. BOSER, "A Micromachine-Based RF Low-Noise Voltage-Controlled Oscillator", IEEE 1997 Custom Integrated Circuits Conference, May 1997, pp.431-434, on a également décrit des microcomposants dans lesquels l'armature fixe est réalisée en aluminium.

La couche devant donner le futur volume entre la plaque fixe et l'armature mobile, est constituée d'un matériau sacrificiel déposé au-dessus de la couche formant l'armature fixe par tout procédé compatible avec le type du microcomposant que l'on souhaite réaliser. Ainsi, ce matériau peut être de façon classique du dioxyde de silicium (SiO₂) ou un composé dérivé qui sera éliminé par attaque acide.

La couche supérieure, formant l'armature déformable du microcomposant est classiquement réalisée en polysilicium obtenu par dépôt LPCVD (signifiant "low pressure chemical vapor deposition" ou "dépôt chimique phase vapeur à basse pression), et suffisamment dopé pour réduire sa résistivité. Certaines techniques proposent un revêtement conducteur disposé au-dessus du polysilicium pour en diminuer la résistivité apparente. Cette armature mobile s'ancre sur le substrat au travers de via, c'est-à-dire de trous gravés dans l'oxyde et/ou le film sacrificiel. Cette armature mobile et déformable peut également être légèrement texturée par des plots gravés partiellement dans l'oxyde ou le film sacrificiel avant dépôt de ce dernier. Cette texturation permet de donner un certain relief à la face inférieure de l'armature mobile, et de limiter la superficie de contact entre la plaque fixe et l'armature mobile dans le cas où elles viennent à se toucher. On évite ainsi les phénomènes de collage.

Pour permettre la dissolution de la couche sacrificielle par attaque chimique, ou tout procédé permettant une gravure isotropique, il est indispensable que la couche constituant l'armature mobile soit également percée dans sa totalité sous forme de motifs réguliers et répétés permettant le passage de la solution de dissolution.

Un inconvénient majeur de ce type de procédé est que le dépôt de couche de polysilicium nécessite l'emploi d'une technique à haute température qui n'est pas compatible avec un dépôt sur des couches semi-conductrices dont les fonctionnalités risquent d'être fortement modifiées et dégradées par la chaleur. Il est donc impossible avec ce genre de technique de réaliser des microcomposants directement au-dessus de circuits intégrés existants par une technique de "post processing".

L'invention se propose donc de pallier ces différents inconvénients.

### Exposé de l'invention

L'invention concerne donc un procédé de fabrication de microcomposants électroniques du type capacité variable ou microswitch comprenant une armature fixe et une membrane déformable située en regard l'une de l'autre.

Ce procédé se caractérise en ce qu'il comporte les étapes suivantes, consistant :
◆ à déposer une première couche métallique de forme complexe sur une couche d'oxyde, ladite première couche métallique étant destinée à former l'armature fixe ;
◆ à déposer un ruban métallique formant bordure sur au moins une partie de la périphérie et de part et d'autre de l'armature fixe, ledit ruban étant destiné à servir d'espaceur entre l'armature fixe et la membrane déformable ;
◆ à déposer une couche de résine sacrificielle sur au moins la superficie de ladite armature fixe ;
◆ à générer par lithographie une pluralité de caissons sur la surface de ladite couche de résine sacrificielle ;
◆ à déposer par électrolyse, à l'intérieur des caissons formés sur la résine sacrificielle, au moins une zone métallique destinée à former la membrane déformable, cette zone métallique s'étendant entre des sections du ruban métallique situées de part et d'autre de ladite armature fixe ;
◆ à éliminer la couche de résine sacrificielle.

Autrement dit, le procédé conforme à l'invention permet une réalisation de membranes déformables réalisées par électrolyse, procédé réalisé à température ambiante, ce qui permet donc la mise en place du microcomposant sur divers substrats, y compris les circuits intégrés.

Ainsi, selon une première famille d'applications, le procédé conforme à l'invention peut être mis en oeuvre en utilisant comme couche d'oxyde une couche de quartz pour former des composants incorporant uniquement des microcapacités ou des microswitch.

Dans un autre type d'applications, le procédé peut être mis en oeuvre en utilisant comme couche d'oxyde, une couche d'oxyde déposée sur un circuit intégré de sorte que les microcapacités ou les microswitchs peuvent être mis en place directement au-dessus du circuit intégré, et interagir avec des zones fonctionnelles du circuit intégré en limitant au maximum l'influence de la connectique puisque ces microcomposants sont au plus près du circuit intégré. On parvient également à une haute densité d'intégration.

Avantageusement en pratique, la première couche métallique destinée à former l'armature fixe du microcomposant est insérée à l'intérieur d'un logement formé dans la couche d'oxyde. Autrement dit, les armatures métalliques fixes peuvent être obtenues par un procédé de métallisation "damascène", ce qui permet d'obtenir des composants particulièrement fiables, car solides et résistants aux vibrations. En outre, grâce à l'excellente planéité des couches obtenues par ce procédé, il est possible de superposer plusieurs couches sans cumuler des irrégularités de topologie. Les opérations subséquentes en sont ainsi facilitées.

Avantageusement en pratique, la première couche métallique formant l'armature fixe comporte un prolongement associé à un plot de connexion monté sur ou à l'intérieur de la couche d'oxyde. Ce plot de connexion permet la liaison du microcomposant avec soit le circuit intégré sous-jacent, soit d'autres parties d'un circuit électronique.

Selon une autre caractéristique de l'invention, le ruban espaceur est présent sur la périphérie de l'armature fixe, sur deux côtés opposés de cette dernière. Les segments de ce ruban servent alors de support aux extrémités des membranes déformables.

En pratique, le ruban espaceur peut être constitué d'une bande continue, ou bien alors avantageusement par une succession de segments unitaires, présent uniquement dans les zones recevant les extrémités des membranes déformables.

Avantageusement en pratique, la couche de résine sacrificielle est déposée de telle sorte qu'elle recouvre en partie le ruban périphérique espaceur. De la sorte, lorsque la membrane déformable est déposée par dessus la couche de résine sacrificielle, sa zone de jonction avec le ruban espaceur présente des ruptures de pente, facilitant la flexion de la membrane déformable.

Avantageusement en pratique, le procédé conforme à l'invention comporte également une étape consistant à graver la couche d'oxyde pour former une ou plusieurs gorges d'ancrage destinées à accueillir une partie du ruban périphérique, ou bien encore une partie des extrémités de la membrane déformable. Cette gorge d'ancrage est disposée directement à l'extérieur du ruban périphérique, ou bien encore en partie en dessous du ruban périphérique. Cette gorge reçoit une partie du ruban périphérique ou bien encore une partie de la membrane pour en assurer un ancrage profond à l'intérieur du substrat, ce qui augmente la robustesse du microcomposant.

Avantageusement en pratique, on a déterminé que l'ancrage était satisfaisant lorsque la gorge a une largeur voisine de deux fois l'épaisseur de la membrane déformable, et que complémentairement, la profondeur de la gorge est supérieure à une fois et demi sa largeur.

Selon une autre caractéristique de l'invention, le procédé peut comporter en outre une étape consistant, après le dépôt de l'armature fixe, à déposer un film de matériau diélectrique, destiné à éviter le collage de la membrane déformable sur la plaque fixe. On évite ainsi que le contact direct entre l'armature fixe et l'armature déformable qui pourrait causer un collage de ces deux armatures, et donc la détérioration du microcomposant. La valeur de capacité par unité de surface peut, en outre, se trouver améliorée dans le cas où la constante diélectrique du film supplémentaire est supérieure à celle de l'air.

Selon une autre caractéristique de l'invention, il est possible de compléter le procédé conforme à l'invention en additionnant une étape supplémentaire consistant, après élimination de la résine sacrificielle, à réaliser sur la face supérieure de la ou les membranes déformables, des zones en relief aptes à modifier le moment d'inertie de surface de la membrane déformable, de façon à réaliser des membranes à déformation programmée. En effet, comme déjà dit, la modification de la capacité du microcomposant peut venir de la modification de l'écartement de la membrane déformable par rapport à la membrane fixe lorsque ces dernières sont soumises à une composante continue de tension. Il est donc possible, grâce à cette disposition, d'adapter la déformation de la membrane déformable, et donc la variation de la capacité, à une variation de la composante continue à laquelle est soumis le microcomposant.

Avantageusement en pratique, les reliefs réalisés sur les membranes peuvent être des nervures longitudinales.

Avantageusement en pratique, les métaux utilisés pour réaliser différentes plaques et armatures peuvent être choisis parmi le groupe comprenant notamment le cuivre, le chrome, le nickel et des alliages incluant ces métaux. Des métaux différents peuvent être utilisés pour réaliser les armatures ainsi que le ruban espaceur. Le choix des différents matériaux et des différentes conditions d'électrolyse permet d'établir avec précision les contraintes internes de la membrane déformable.

Grâce à cette caractéristique, il est possible de donner à la membrane déformable une section transversale qui est variable sur sa longueur.

### Description sommaire des figures

La manière de réaliser l'invention ainsi que les avantages qui en découlent ressortiront bien de la description du mode de réalisation qui suit, à l'appui des figures annexées dans lesquelles :
La figure 1 est une vue de dessus d'un microcomposant réalisé conformément au procédé de l'invention, illustré après le dépôt de l'armature fixe.
La figure 2 est une vue en coupe de la figure 1 selon les flèches II-II'.
La figure 3 est une vue de dessus du microcomposant conforme à l'invention illustrée après la gravure des gorges d'ancrage.
La figure 4 est une vue en coupe de la figure 3 selon les flèches III-III'.
La figure 5 est une vue de dessus du microcomposant réalisé conformément à l'invention après le dépôt des rubans espaceurs.
La figure 6 est une vue en coupe de la figure 2 selon les flèches IV-IV'.
La figure 7 est une vue de dessus d'un microcomposant en cours de réalisation conforme à l'invention, après dépôt de la couche de résine sacrificielle.
La figure 8 est une vue en coupe de la figure 7 selon les flèches VIII-VIII'.
La figure 9 est une vue de dessus du microcomposant conforme à l'invention, illustré après dépôt de l'armature déformable.
La figure 10 est une vue en coupe de la figure 9 selon les flèches X-X'.

### Manière de réaliser l'invention

Comme déjà dit, l'invention concerne un procédé permettant la réalisation de microcomposants tels que des microcondensateurs ou des microswitch. Grâce à l'utilisation d'étapes d'électrolyse ne nécessitant pas de hautes températures, il est possible de mettre en oeuvre ce procédé pour réaliser les microcomposants soit directement sur des couches de quartz, soit directement sur des circuits intégrés pré-existants.

La mise en oeuvre du procédé pouvant être faite sur ces deux types de support, on ne décrira pas ci-après la structure interne du substrat sur lequel est réalisé le microcomposant conforme à l'invention.

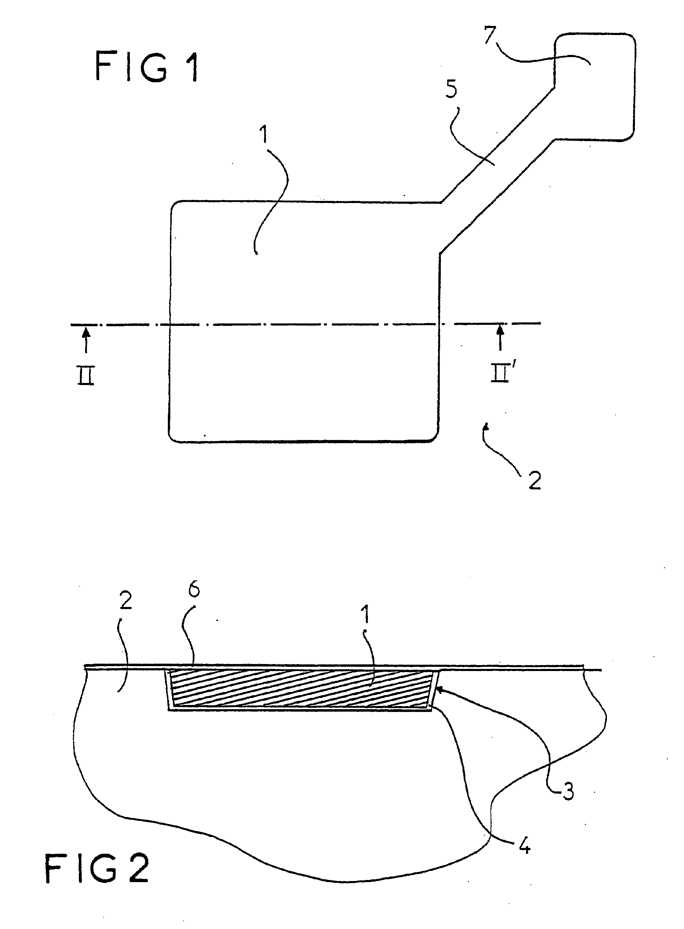

Ainsi, comme on le voit à la figure 1, la première série d'étape du procédé consiste à réaliser une armature fixe (1) sur un substrat (2). Le substrat (2) peut être soit une couche de quartz dans le cas où on réalise un microcomposant indépendamment d'un circuit intégré, ou bien encore de la couche d'oxyde obtenue par exemple par PECVD signifiant "dépôt chimique phase vapeur assisté par plasma" ou "plasma enhanced chemical vapor deposition", typiquement d'épaisseur de quelques microns, qui recouvre un circuit intégré.

Pour la réalisation de l'armature fixe (1), on procède tout d'abord à la réalisation d'un caisson (3) par gravure dans la couche d'oxyde (2). La couche d'oxyde (2) ainsi que le caisson (3) reçoivent ensuite le dépôt d'une sous-couche de croissance métallique (4) typiquement en un alliage de cuivre et de titane.

Le caisson réalisé présente une forme englobant à la fois celle de l'armature fixe (1), ainsi que celle d'un prolongement (5) formant le câblage d'amenée de tension vers l'armature fixe (1). Cette amenée de tension (5) peut se prolonger par un plot (7) permettant la réalisation de la connectique avec le microcomposant.

Par la suite, on procède à l'électrolyse de cuivre au-dessus de la sous-couche (4) de croissance. Le métal utilisé pour l'électrolyse est préférentiellement du cuivre, choisi pour sa faible résistivité. L'électrolyse se poursuit jusqu'à ce que la couche de cuivre (1) ait une épaisseur suffisante pour remplir le caisson (3) ménagé dans la couche d'oxyde (2).

Par la suite, comme illustré en figures 1 et 2, on procède à une planarisation de la couche de cuivre (1) permettant de lui donner un état de surface d'une très grande planéité.

Par la suite, on réalise le dépôt d'une couche de matériau diélectrique (6) typiquement de l'oxyde ou du nitrure de silicium PECVD. Ce film d'oxyde (6) présente l'épaisseur minimale permettant d'éviter les phénomènes de collage de la membrane déformable sur l'armature fixe (1). L'interposition de ce film d'oxyde (6) augmente légèrement la capacité du condensateur qui sera formé avec l'armature mobile, dans le cas où la constante diélectrique de ce film est supérieure à celle de l'air.

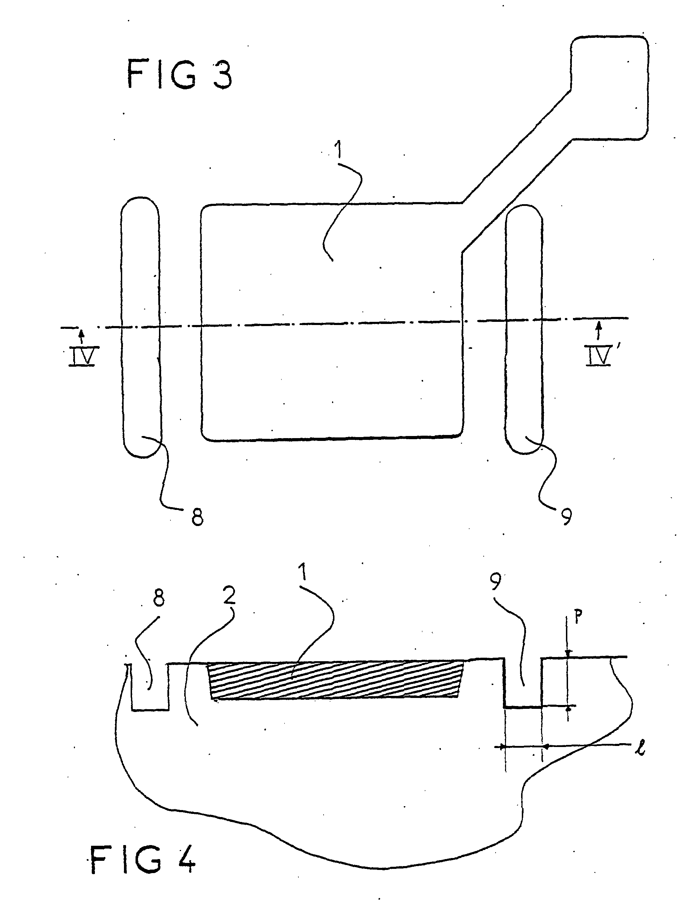

Par la suite, comme illustré aux figures 3 et 4, on procède à une gravure de la couche de substrat (2) par un procédé traditionnel classique de lithogravure permettant de créer une gorge d'ancrage périphérique (8, 9). De façon générale, cette gorge a une largeur (ℓ) voisine de deux fois l'épaisseur de la future membrane déformable supérieure. La profondeur (p) de cette gorge (8, 9) est au moins égale à une fois et demi sa largeur (ℓ).

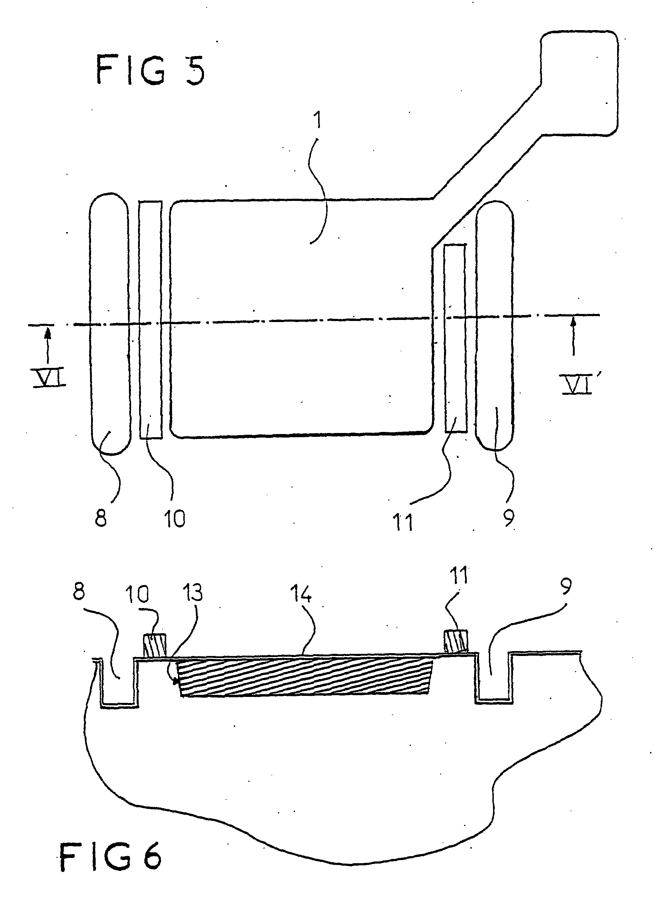

Par la suite, on dépose une nouvelle sous-couche de croissance (14) sur la surface de l'ensemble de la zone du microcomposant. Par lithogravure, on recouvre cette sous-couche de croissance sauf dans les zones de réalisation des bordures périphériques, de manière à créer des zones de croissance pour l'électrolyse du ruban périphérique (voir figure 5). Ce ruban (10, 11) est ensuite formé par électrolyse. Ce ruban (10, 11) peut être en un matériau identique ou différent de celui servant pour l'armature fixe (1) et pour l'armature mobile, en fonction du résultat souhaité. Dans la forme illustrée, le ruban (10) est disposé entre la gorge (8) et la limite (13) de l'armature fixe (1), mais dans certains cas de figure, on peut envisager que ce ruban périphérique (10, 11) soit en partie encastré à l'intérieur de la gorge d'ancrage (8).

Par ailleurs, la forme illustrée de la figure 5 montre un ruban périphérique situé de part et d'autre de l'armature fixe (1), et constituée d'une seule bande (10, 11) de chaque côté. Dans le cas où l'on souhaite réaliser plusieurs membranes déformables au-dessus d'une même armature fixe commune (1), le ruban métallique peut alors être segmenté en autant de portions que nécessaire.

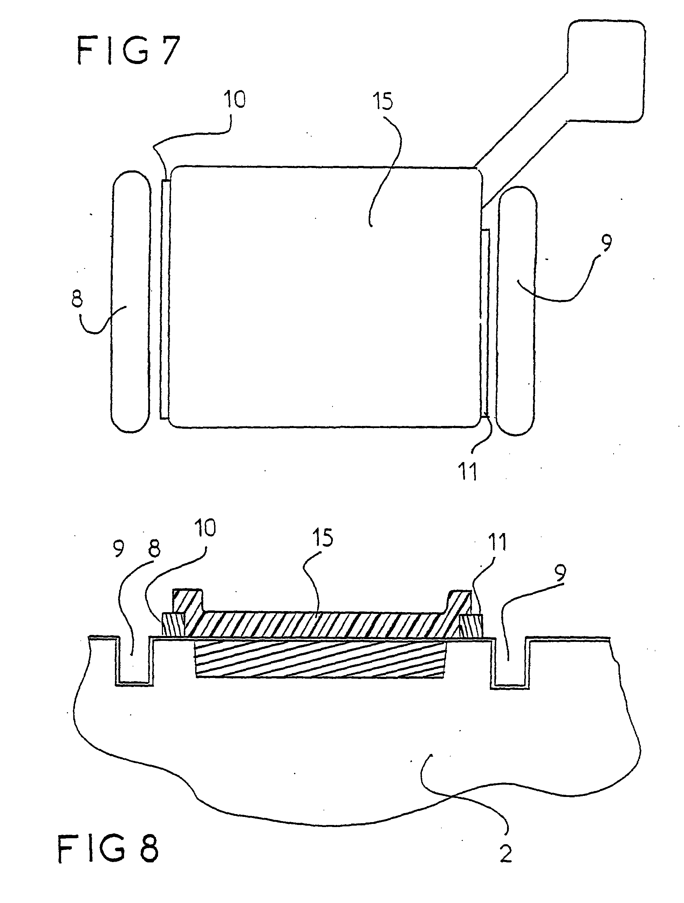

Par la suite, et comme illustré aux figures 7 et 8, on procède au dépôt d'une résine sacrificielle (15) dont l'épaisseur, voisine de 2 micromètres, correspond sensiblement à l'entrefer qui existera entre l'armature fixe (1) et la membrane déformable. Typiquement, cette résine présente une épaisseur sensiblement égale à celle du ruban périphérique (10, 11). Bien entendu, cette valeur d'épaisseur est donnée à titre d'exemple, et peut être adaptée en fonction de la géométrie liée aux applications. Le matériau utilisé pour cette résine fait partie des matériaux classiquement utilisés en micro-électronique.

Par la suite, on dépose une sous-couche de croissance électrolytique au dessus de la couche de résine sacrificielle (15), de la partie apparente du ruban (10, 11), et des gorges d'ancrage (8, 9). Cette couche est typiquement en titane ou en chrome, choisie pour ses capacités d'adhérence sur la silice. On procède ensuite à une lithographie pour recouvrir cette sous-couche de croissance et ne la conserver apparente qu'aux endroits nécessaires sur la couche de résine sacrificielle (15), ainsi qu'au niveau du ruban périphérique (10, 11) et gorge d'ancrage (8, 9).

On procède par la suite à une électrolyse permettant de générer la membrane déformable (20) au-dessus de la sous-couche de croissance restante. Le choix du métal utilisé dépend des contraintes requises pour la rigidité de la membrane.

Par la suite, on procède à l'élimination de la couche de résine sacrificielle et de la sous-couche de croissance préalablement recouverte par lithogravure.

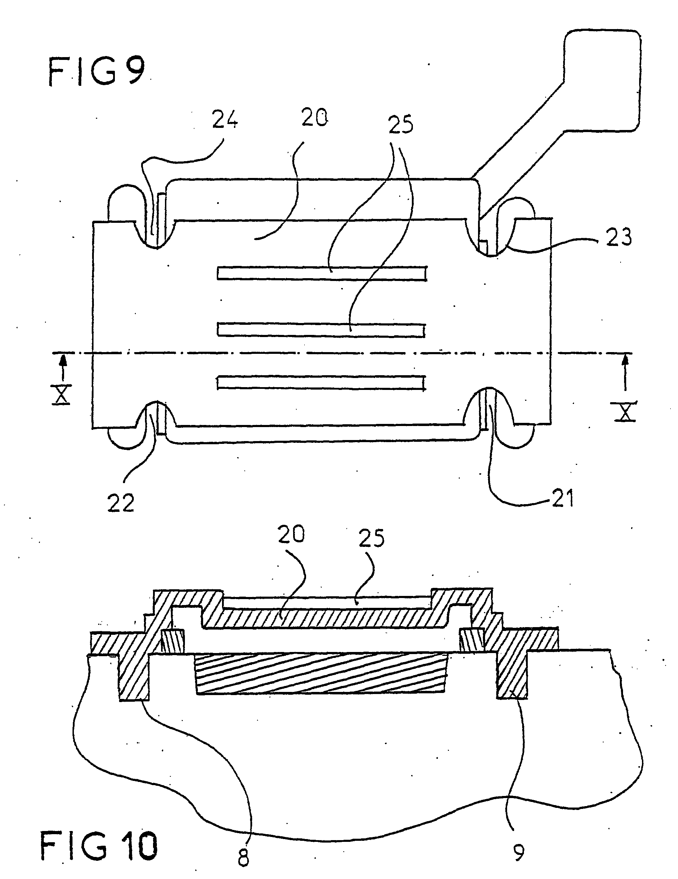

Comme illustré à la figure 9, la membrane mobile (20) présente, à l'aplomb de la bordure de l'armature fixe, des échancrures (21-24) définissant une ouverture pour le passage des produits assurant la dissolution de la résine. Ces échancrures sont notamment utiles dans le cas où plusieurs membranes déformables sont disposées côte à côte. Dans le cas d'un microcomposant ne possédant qu'une membrane mobile de plus grandes dimensions, cette dernière est alors percée de trous ou d'échancrures sur une majeure partie de sa surface pour permettre la circulation de produits nécessaires à la dissolution de la résine sacrificielle.

Par la suite, conformément à une autre caractéristique de l'invention, on procède au dépôt d'une seconde résine au-dessus de la membrane déformable. Cette seconde résine peut être insolée dans des zones caractéristiques pour pour laisser apparaître certaines zones de l'armature déformable (20) elle-même. Sur ces zones, il est alors possible par une opération d'électrolyse supplémentaire de former des membrures (25) dont la rigidité vient s'ajouter et se combiner avec celles de la membrane déformable. On obtient ainsi une modification de moment d'inertie de surface qui modifie la loi de déformation de la membrane.

Avantageusement, ces membrures supplémentaires (25) présentent une épaisseur pouvant aller jusqu'à 30 microns, et peuvent être réalisées en nickel par exemple. Par la suite, on procède à l'élimination de la résine supplémentaire déposée au-dessus de la membrane déformable (20).

Bien évidemment, les différentes épaisseurs, les dimensions et le choix des matériaux utilisés sont faits en fonction des contraintes technologiques des applications souhaitées, et ne sont pas limitées aux seules valables décrites ci-avant. Ainsi, il est possible d'obtenir des condensateurs dont la capacité peut varier entre quelques dizaines de femtoFarads, et quelques dizaines de picoFarads. En fonction de l'application, l'entrefer peut aller jusqu'à quelques micromètres. Bien entendu, ces valeurs sont données à titre d'exemple et peuvent varier en fonction des types de composants réalisés, et de leurs applications.

Il ressort de ce qui précède que le procédé conforme à l'invention présente de multiples avantages et notamment :
◆ la possibilité de réaliser un condensateur à capacité variable dont l'entrefer, ou la distance entre son armature fixe et son armature variable est particulièrement régulière, ce qui rend le composant très précis ;
◆ la possibilité d'utiliser les microcomposants en tant que microswitch.: pour des applications fonctionnant à dans le domaine des radiofréquences (de 100 MégaHertz à 5 GigaHertz), l'utilisation de métaux à faible résistivité comme le cuivre ou l'or s'avère avantageuse en ce qui concerne les pertes d'insertion du contact métal/métal

- pour des applications dans le domaine des hautes fréquences (de 5 GigaHertz à 100 GigaHertz), l'utilisation d'une couche intermédiaire diélectrique permet d'obtenir un contact capacitif, sans risque de provoquer un collage entre la membrane mobile et la membrane fixe ;
   ◆ la possibilité de réaliser une pluralité de condensateurs variables partageant une même armature fixe ;
   ◆ l'utilisation de températures relativement faibles, permettant la mise en oeuvre du procédé directement au-dessus de circuits intégrés sans risque de modifier les fonctionnalités desdits circuits ;
   ◆ la possibilité de modifier la structure mécanique de la membrane déformable pour adapter sa loi de déformation avec l'application voulue.

## Revendications

1. Procédé de fabrication de microcomposants électroniques, du type capacité variable ou microswitch, comprenant une armature fixe (1) et une membrane (20) déformable situées en regard l'une de l'autre, **caractérisé en ce qu'**il comporte les étapes suivantes, consistant :
◆ à déposer une première couche métallique sur une couche d'oxyde (2), ladite première couche métallique étant destinée à former l'armature fixe ;
◆ à déposer un ruban métallique (10, 11) sur au moins une partie de la périphérie et de part et d'autre de l'armature fixe (1), ledit ruban étant destiné à servir d'espaceur entre l'armature fixe (1) et la membrane déformable (20) ;
◆ à déposer une couche de résine sacrificielle (15) sur au moins la superficie de ladite armature fixe (1) ;
◆ à générer par lithographie une pluralité de caissons, sur la surface de ladite couche de résine sacrificielle ;
◆ à déposer par électrolyse, à l'intérieur des caissons formés sur la résine sacrificielle (15), au moins une zone métallique destinée à former la membrane déformable (20), cette zone métallique s'étendant entre des sections du ruban métallique (10, 11) situées de part et d'autre de ladite armature fixe (1);
◆ à éliminer la couche de résine sacrificielle (15).

2. Procédé selon la revendication 1, **caractérisé en ce que** la couche d'oxyde (2) est déposée sur un circuit intégré.

3. Procédé selon la revendication 1, **caractérisé en ce que** la couche d'oxyde (2) est en quartz.

4. Procédé selon la revendication 1, **caractérisé en ce que** la première couche métallique destinée à former la plaque fixe est insérée à l'intérieur d'un logement (3) formé dans la couche d'oxyde (2).

5. Procédé selon la revendication 1, **caractérisé en ce que** la première couche métallique comporte un prolongement (5) associé à un plot de connexion (6).

6. Procédé selon la revendication 1, **caractérisé en ce que** le ruban (10, 11) est présent sur la périphérie de l'armature fixe (1), sur deux côtés opposés de cette dernière.

7. Procédé selon la revendication 1, **caractérisé en ce que** le ruban est constitué d'une succession de segments unitaires.

8. Procédé selon la revendication 1, **caractérisé en ce que** la couche de résine sacrificielle (15) recouvre en partie le ruban périphérique (10, 11).

9. Procédé selon la revendication 1, **caractérisé en ce qu'**il comporte également une étape consistant à graver la couche d'oxyde pour former une ou plusieurs gorges d'ancrage (8, 9) destinées à accueillir une partie du ruban périphérique (10, 11).

10. Procédé selon la revendication 1, **caractérisé en ce qu'**il comporte également une étape consistant à graver la couche d'oxyde pour former une ou plusieurs gorges d'ancrage (8, 9) destinées à accueillir une partie des extrémités de la membrane déformable (20).

11. Procédé selon l'une des revendications 9 ou 10, **caractérisé en ce que** la gorge d'ancrage (8, 9) a une largeur (ℓ) voisine de deux fois l'épaisseur de la membrane déformable (20).

12. Procédé selon la revendication 11, **caractérisé en ce que** la gorge d'ancrage (8, 9) a une profondeur (p) supérieure à une fois et demi sa largeur (ℓ).

13. Procédé selon la revendication 1, **caractérisé en ce qu'**il comporte en outre une étape consistant, après le dépôt de l'armature fixe, à déposer un film (6) d'un matériau diélectrique, destiné à éviter le collage de la membrane déformable sur ladite armature fixe.

14. Procédé selon la revendication 1, **caractérisé en ce qu'**il comporte en outre une étape consistant, après élimination de la résine sacrificielle (15), à réaliser sur la face supérieure de la ou les membranes déformables, des zones en relief (25) aptes à modifier le moment d'inertie de surface de la membrane déformable, de façon à réaliser des membranes à déformation programmée.

15. Procédé selon la revendication 14, **caractérisé en ce que** les reliefs sont des nervures longitudinales (25).

16. Procédé selon la revendication 1, **caractérisé en ce que** le métal utilisé pour réaliser l'armature fixe et la membrane déformable, est choisi dans le groupe comprenant le cuivre, le chrome, le nickel et les alliages incluant ces métaux.

17. Microcomposant du type capacité variable ou microswitch, comprenant :
◆ une armature fixe métallique (1) insérée dans une couche d'oxyde (2) ;
◆ au moins deux rubans métalliques (10, 11) disposés en périphérie et de part et d'autre de ladite armature fixe (1) ;
◆ au moins une membrane déformable métallique (20) disposée en regard de ladite armature fixe (20), et reposant dans ses deux extrémités sur les deux rubans métalliques.

18. Microcomposant selon la revendication 17, **caractérisé en ce qu'**il est disposé sur la face supérieure d'un circuit intégré.

19. Microcomposant selon la revendication 17, **caractérisé en ce que** la membrane déformable (20) comporte sur sa face supérieure des reliefs (25) destinés à modifier son moment d'inertie de surface.

20. Microcomposant selon la revendication 17, **caractérisé en ce que** l'armature fixe (1) est recouverte d'un film (6) d'un matériau diélectrique destiné à éviter le collage de la membrane déformable (20) sur l'armature fixe (1).

21. Microcomposant selon la revendication 17, **caractérisé en ce qu'**il comporte des gorges d'ancrage (8, 9) formées dans la couche d'oxyde (2), et disposées à l'extérieur de l'armature fixe, lesdites gorges (8, 9) étant emplies par une fraction des rubans espaceurs (10, 11) et/ou de la membrane déformable (20).

22. Microcomposant selon la revendication 17, **caractérisé en ce que** le métal constituant l'armature fixe et la membrane mobile, s'est choisi dans le groupe comprenant le cuivre, le nickel et le chrome.

23. Microcomposant selon la revendication 17, **caractérisé en ce que** la section transversale de la membrane déformable (20) est variable sur la longueur de ladite membrane déformable.
